Europäisches Patentamt

European Patent Office

Office européen des brevets

(11) Numéro de publication: **0 263 788 B1**

(12) **FASCICULE DE BREVET EUROPEEN**

(45) Date de publication de fascicule du brevet:
28.08.91

(51) Int. Cl.⁵: **C23C 16/50**, C23C 16/22

(21) Numéro de dépôt: 87810548.5

(22) Date de dépôt: 23.09.87

(54) **Procédé et installation de dépôt de silicium amorphe hydrogène sur un substrat dans une enceinte à plasma.**

(30) Priorité: 26.09.86 CH 3868/86

(43) Date de publication de la demande:
13.04.88 Bulletin 88/15

(45) Mention de la délivrance du brevet:
28.08.91 Bulletin 91/35

(84) Etats contractants désignés:
AT BE CH DE ES FR GB GR IT LI LU NL SE

(56) Documents cités:
US-A- 4 226 898
US-A- 4 406 765

(73) Titulaire: **INSTITUT DE MICROTECHNIQUE Université de Neuchâtel 2, rue Bréguet CH-2000 Neuchâtel(CH)**

(72) Inventeur: **Curtins, Hermann Giessen 165 CH-3236 Gampelen(CH)**

(74) Mandataire: **Nithardt, Roland Cabinet Roland Nithardt Conseils en Propriété Industrielle S.A. Y-Parc Scientifique et Technologique Chemin de la Sallaz Case postale 3347 CH-1400 Yverdon-les-Bains(CH)**

Rank Xerox (UK) Business Services

## Description

La présente invention concerne un procédé de dépôt d'un film semi-conducteur de silicium amorphe hydrogéné ou d'un alliage de silicium amorphe hydrogéné sur un substrat, dans une enceinte à plasma contenant au moins une paire d'électrodes couplée à un générateur électrique à haute fréquence, dans lequel on relie le substrat à une électrode, le substrat étant placé à une distance **d** de l'autre électrode, on introduit dans l'enceinte un gaz contenant au moins un composé de silicium et l'on applique aux électrodes une puissance électrique de haute fréquence **f** pour produire un plasma entre les électrodes. L'invention concerne également une installation pour la mise en oeuvre de ce procédé.

Le dépôt de silicium amorphe hydrogéné (a-Si:H) dans un réacteur à plasma est décrit notamment dans le brevet US-4'226'898 et il est pratiqué couramment, par exemple à partir de composés du type silane ($SiH_4$, $Si_2H_6$, etc.) et de gaz dopants, pour réaliser des éléments de photodétecteurs ou de cellules photovoltaïques. On dépose également des couches amorphes d'alliages de silicium hydrogénés, par exemple selon les formules $a\text{-}Si_xGe_{1-x}\text{:}H$, $a\text{-}Si_xC_{1-x}\text{:}H$ ou $a\text{-}Si_xN_{1-x}\text{:}H$. En application industrielle, on vise avant tout à obtenir une qualité suffisante du produit, en particulier un nombre limité de défauts par unité de volume, (défauts produisant des états localisés dans la bande d'énergie interdite du semi-conducteur) avec une vitesse de dépôt aussi grande que possible, donc un coût modéré. La plupart du temps, le plasma est produit par des décharges en radiofréquence (RF) entre deux électrodes dont l'une porte le substrat, le plasma étant ainsi couplé capacitivement à un générateur de haute fréquence.

Les paramètres intervenant sur le processus de dépôt sont nombreux et englobent notamment : la distance entre les électrodes, la température du substrat, le mélange gazeux utilisé, la pression et le débit d'introduction du gaz dans l'enceinte, la puissance et la fréquence de décharge en RF. En outre, il importe de confiner le plasma autant que possible dans la zone située entre les deux électrodes, ce qui peut se faire notamment grâce à un choix approprié des paramètres suivants : pression, distance entre électrodes, puissance RF. Pour obtenir une vitesse de dépôt élevée, il convient d'augmenter principalement la concentration du plasma et/ou la densité de puissance RF par unité de surface du substrat. Toutefois, l'augmentation de ces paramètres s'est heurtée jusqu'à maintenant à des limites dues à l'augmentation du taux de défauts dans le film déposé, c'est-à-dire du nombre de défauts par unité de volume, en particulier à cause d'un phénomène de polymérisation dans la phase gazeuse, de sorte que les meilleures vitesses de dépôt obtenues actuellement au stade industriel ne dépassent en général pas 0,4 nm/s (4 Å/s) pour un taux de défauts $N_s$, mesuré par la méthode PDS (Photothermal Deflection Spectroscopy), de l'ordre de 1-$5\times10^{16}$/cm³ pour un film ayant une épaisseur de l'ordre de 1 µm. Ainsi, le dépôt d'un tel film dure au moins trois quarts d'heure (la méthode PDS est décrite par W:B Jackson et N.M.Amer dans Phys. Rev. B, 25, pp. 5559-5562).

Un exemple des tentatives pour accroître la vitesse de dépôt est donné par T. Hamasaki et al, dans Appl. Phys. Letters 44 (6) 1984, p.600-602. Dans ce cas, un confinement du plasma par un grillage entourant la zone des électrodes et mis à terre a permis d'obtenir des vitesses de dépôt de l'ordre de 4 à 5 nm/s (40 à 50 Å/s) en utilisant du gaz de silane ( $SiH_4$) pur et une fréquence standard de 9 MHz. Cependant, à part les conductivités dans l'obscurité et à la lumière, les auteurs ne donnent pas d'indications précises sur la qualité du dépôt obtenu et on peut s'attendre à une valeur de $N_s$ relativement élevée.

Le brevet US-4'406'765 décrit un procédé dans lequel le plasma est produit par superposition d'un champ électrique continu (DC) et d'un champ électrique à haute fréquence entre 0,1 MHz et 100 MHz (ou d'un champ électrique pulsé), afin d'obtenir avant tout une vitesse de dépôt très élevée. La qualité du film obtenu n'est pas indiquée en détails : il faut s'attendre à ce qu'elle soit inférieure à ce qui est généralement demandé pour les cellules solaires. Cette publication n'indique pas non plus si certaines valeurs de fréquence sont préférables dans la très large gamme proposée. On peut donc penser qu'une modification de la fréquence n'a pas d'effet sensible dans cette technique.

L'objet de la présente invention consiste à fournir des moyens simples et efficaces permettant de perfectionner des procédés connus du type indiqué plus haut, de manière à augmenter la vitesse de dépôt sans augmenter le nombre des défauts, ou même en le réduisant par rapport aux dépôts obtenus par les procédés classiques.

Une idée de base de la présente invention consiste à rechercher une augmentation de vitesse de dépôt en appliquant aux électrodes une tension électrique alternative de radiofréquence plus élevée que celle qu'on a utilisée jusqu'à maintenant. La plupart des recherches faites sur le dépôt de silicium amorphe hydrogéné se sont faites avec une fréquence de 13,56 MHz parce qu'il s'agit d'une fréquence industrielle, ne produisant pas de perturbations majeures sur les communications radio, et que les appareils utilisant cette fréquence sont largement répandus. En outre, une augmentation de la fréquence dans l'enceinte à plasma tend à produire des décharges parasites entre une électrode et son support ou l'enceinte, de sorte qu'on a en général évité les fréquences plus élevées. Enfin, la plupart de chercheurs ont estimé jusqu'à maintenant qu'il n'était pas opportun d'utiliser une fréquence sensiblement supérieure à celle du plasma, c'est-à-dire la fréquence de relaxation des ions, qui est de l'ordre de 1 à 8 MHz. Au contraire, les recherches qui sont à la base de l'invention montrent qu'on peut atteindre des résultats très avantageux en appliquant aux électrodes une fréquence relativement élevée, en combinaison avec une géométrie particulière du réacteur.

Selon un premier aspect, l'invention concerne un procédé du type indiqué en préambule, caractérisé en ce que la fréquence **f** est comprise entre 25 et 150 MHz, et en ce que le rapport **f/d** entre la fréquence **f** et la distance **d** est compris entre 30 et 100 MHz/cm. De préférence, la distance **d** est comprise entre 1 et 3 cm.

Dans les formes de réalisation particulièrement avantageuses du procédé, le rapport **f/d** est compris entre 30 et 80 MHz/cm. De plus, la fréquence **f** est comprise entre 30 et 100 MHz, et la distance **d** est comprise entre 1 et 2,5 cm. En ce qui concerne la puissance électrique injectée **P**, c'est-à-dire la puissance dissipée dans le plasma et mesurée aux bornes des deux électrodes, le rapport entre cette puissance et le volume **V** $_p$ du plasma se trouvant entre les deux électrodes est compris entre 0,02 et 0,2 W/cm$^3$ et de préférence entre 0,04 et 0,15 W/cm$^3$. En outre, pendant la phase de dépôt, on maintient dans l'enceinte une pression comprise de préférence entre 10 et 50 Pa (0,1 et 0,5 mbar) et l'on maintient le substrat à une température comprise de préférence entre 230 et 350°C.

Le gaz introduit dans l'enceinte peut comprendre une ou plusieurs des substances suivantes : silane ($SiH_4$), disilane ($Si_2H_6$) et/ou des silanes d'ordre supérieur, tétrafluorure de silicium ($SiF_4$), hydrogène ($H_2$). En plus des composés de silicium, le gaz peut comprendre une ou plusieurs substances suplémentaires destinées à déposer un film amorphe contenant un alliage de silicium et d'une autre substance et/ou modifier ou doper le film déposé. Un premier groupe de ces substances comprend le germane ($GeH_4$) et le tétrafluorure de germanium ($GeF_4$). Un second groupe comprend le méthane ($CH_4$) et le tétrafluorure de carbone ($CF_4$). Un troisième groupe comprend l'azote ($N_2$) et l'ammoniac ($NH_3$). Un quatrième groupe comprend la phosphine ($PH_3$) et le diborane ($B_2H_6$). Des substances choisies dans plusieurs de ces groupes peuvent aussi être présentes simultanément dans l'enceinte. Le débit d'introduction du gaz de silane peut être compris entre 0,3 et 2,0 sccm/l de volume intérieur utile de l'enceinte, et de préférence approximativement 1,2 sccm/l (1 sccm = 1 cm$^3$ NTP, c'est-à-dire dans les conditions normales de température et de pression, par minute).

Pour le dépôt d'un film d'alliage silicium-azote, le procédé prévoit avantageusement que le gaz utilisé comprend un mélange de silane et d'ammoniac dans un rapport volumique comprise entre 0,03 et 0,3, la distance **d** entre les électrodes étant comprise entre 1 et 3 cm.

Pour la mise en oeuvre de ce procédé, on peut utiliser une installation du type comportant un générateur de radiofréquences, un réacteur à plasma pourvu d'une enceinte renfermant deux électrodes couplées au générateur par l'intermédiaire d'un réseau d'adaptation, des moyens pour introduire des gaz dans l'enceinte et des moyens pour extraire des gaz de l'enceinte, l'une des deux électrodes étant pourvues d'un support pour le substrat, et l'autre électrode étant disposée à une distance **d** en face du substrat. L'installation selon l'invention est caractérisée en ce que la fréquence **f** délivrable par le générateur est comprise entre 25 et 150 MHz, et en ce que le rapport **f/d** est compris entre 30 et 100 MHz/cm.

La présente invention et ses avantages ressortiront mieux de la description d'un exemple de réalisation, donnée ci-dessous en référence aux dessins annexés, dans lesquels :

La fig. 1 est un schéma simplifié d'une installation pour le dépôt de silicium amorphe hydrogéné sur un substrat dans un réacteur à plasma,

la fig. 2 est une vue schématique en coupe longitudinale du réacteur,

la fig. 3 représente, sous forme de diagrammes schématiques, des vitesses de dépôt **r** et des taux de défauts **N$_s$** obtenus pour différentes fréquences **f** et différentes distances **d** entre électrodes, dans une installation selon les figures 1 et 2,

la fig. 4 est un diagramme similaire à la fig. 3, pour une distance **d** donnée, et

la fig. 5 est une vue schématique en coupe longitudinale, montrant la forme de la zone ou apparaît le plasma pour différentes fréquences.

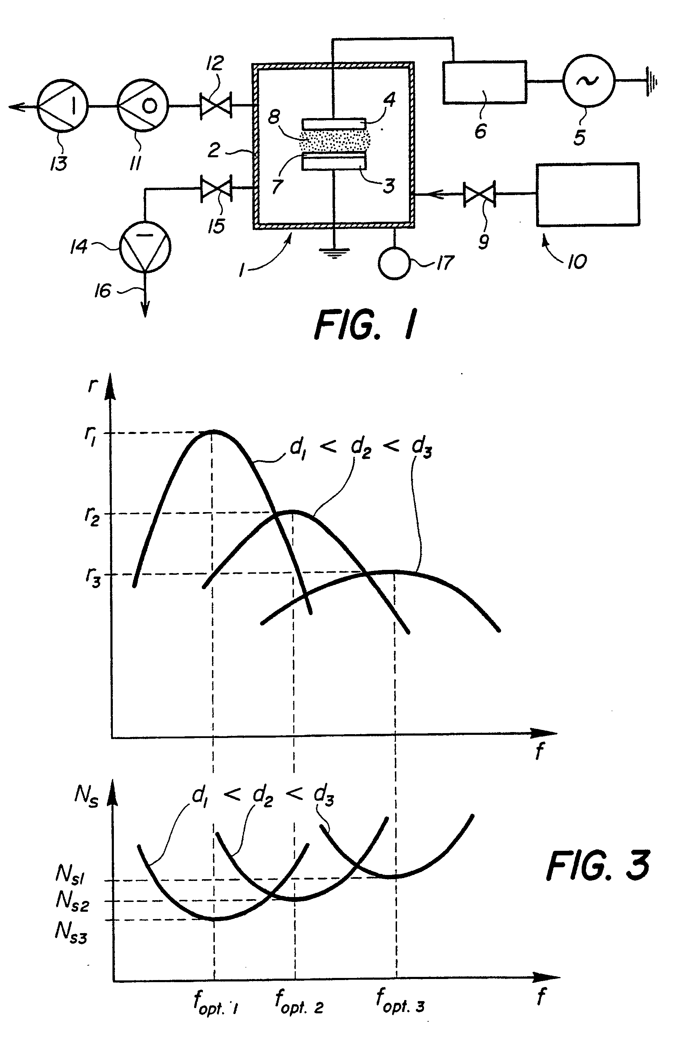

L'installation représentée schématiquement sur la fig. 1 a une configuration générale connue. Elle comprend un réacteur à plasma 1 comportant, à l'intérieur d'une enceinte à vide 2, une première électrode 3 qui est raccordée à la terre (mais qui pourrait être maintenue à un potentiel différent de la terre) et une seconde électrode 4 qui est raccordée à un générateur électrique de radiofréquences 5 par l'intermédiaire d'un réseau d'adaptation 6. Les électrodes 3 et 4 sont disposées l'une en face de l'autre, leurs surfaces respectives étant essentiellement planes. Un substrat 7 en forme de plaque est fixé sur la première électrode 3 de manière que sa surface libre soit située à une distance **d** de la seconde électrode 4. Dans le circuit électrique alimenté par le générateur 5, les électrodes (y compris le substrat) forment ainsi un élément capacitif permettant de créer un plasma 8 par décharge électrique à haute fréquence entre les électrodes lorsqu'un gaz se trouve dans l'enceinte 2 dans des conditions appropriées. Dans le cas présent, le générateur 5 est prévu pour produire des radiofréquences comprises entre 1 et 200 MHz. Il faut remarquer que, dans une installation de ce genre, on pourrait disposer le substrat et les équipements correspondants sur la seconde électrode au lieu de la première, mais cette solution est généralement moins avantageuse pour des raisons d'isolation électrique.

De manière connue, l'installation comporte des moyens 10 d'alimentation en gaz comprenant en particulier un ou plusieurs réservoirs de gaz et des détendeurs correspondants, pour introduire différents gaz (purs ou sous forme de mélanges) dans l'enceinte 2 du réacteur à travers une ou plusieurs vannes d'entrée 9, et des moyens pour extraire les gaz de cette enceinte. Sur la fig. 1, on a représenté une pompe turbomoléculaire 11 dont le côté aspiration est raccordé à l'enceinte 2 par l'intermédiaire d'une vanne 12, la pompe 11 étant suivie d'une première pompe primaire 13. Une seconde pompe primaire 14 est raccordée à l'enceinte 2 par une vanne 15, la sortie de cette pompe étant branchée sur un circuit 16 d'évacuation des gaz. On a représenté également un pressiomètre 17 indiquant la pression dans l'enceinte 2. Par ailleurs, il est prévu divers moyens connus pour chauffer et pour refroidir les électrodes, le substrat et l'enceinte, mais ceux-ci ne sont pas représentés sur la fig.1.

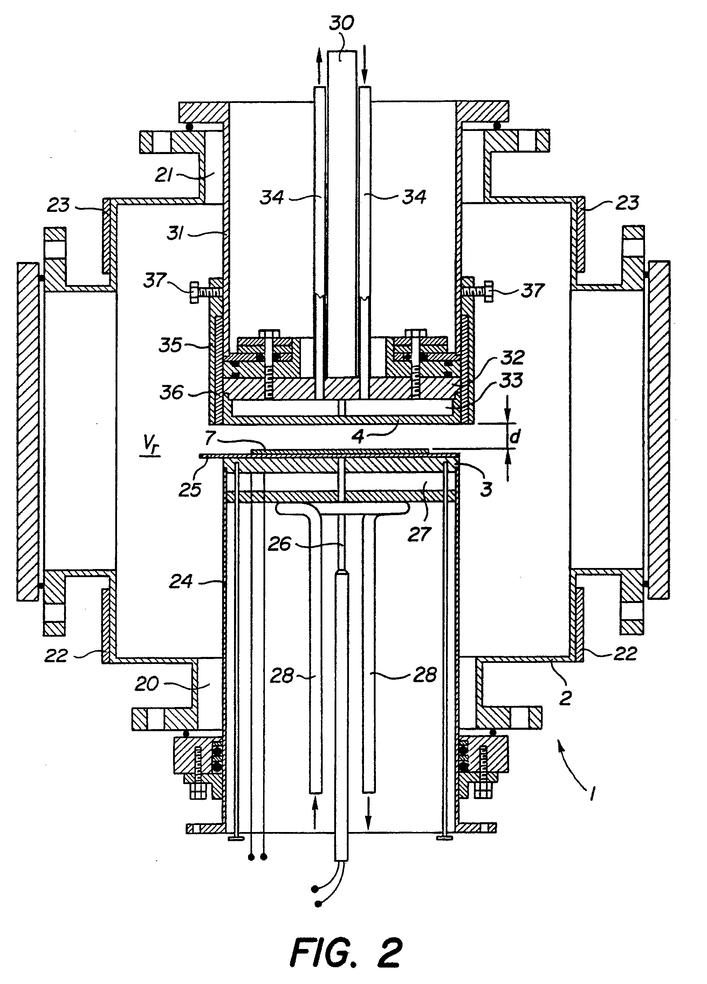

La fig. 2 montre plus en détail la disposition des électrodes 3 et 4 et du substrat 7 dans l'enceinte 2 du réacteur 1. L'enceinte 2 est un récipient fermé approximativement cubique, pourvu d'ouvertures 20 et 21 pour le montage des électrodes 3 et 4 et de plusieurs autres ouvertures pour d'autres composants tels que des tubulures (non représentées) d'introduction et d'extraction des gaz. Dans cet exemple, le volume intérieur utile $V_r$ de l'enceinte 2, c'est-à-dire le volume occupé par les gaz, est de 15 litres. Des corps de chauffe 22 et 23 sont appliqués sur la surface extérieure de l'enceinte 2.

La première électrode 3, c'est-à-dire l'électrode qui est raccordée électriquement à la terre, est montée à l'extrémité d'un porte-électrode tubulaire 24 fixé à l'enceinte 2. Elle est équipée d'un support de substrat 25 qui est facilement interchangeable, d'une sonde de température 26, d'un corps de chauffe électrique 27 et d'un circuit de refroidissement à eau 28, utilisable pour refroidir l'électrode et le substrat à la fin du processus de dépôt.

Pour sa part, la seconde électrode 4, dite électrode active, est raccordée au générateur à haute fréquence au moyen d'une tige conductrice 30 et elle est montée à l'extrémité d'un porte-électrode tubulaire 31 par l'intermédiaire d'une monture isolante 32 qui définit en outre, au dos de l'électrode 4, une chambre de refroidissement 33 raccordée à un circuit d'eau 34. Un écran métallique 35, qui est raccordé électriquement à la terre, entoure latéralement l'électrode 4, dont il est séparé par un espace rempli d'une matière diélectrique constituant une gaine 36 qui empêche l'apparition de décharges sur les côtés de l'électrode 4. De préférence, cette gaine est en matière céramique réfractaire, par exemple en verre. L'écran 35 est fixé sur le porte-électrode 31 au moyen de vis de serrage 37, dans une position réglable longitudinalement. Bien entendu, soit l'une, soit l'autre des électrodes 3 et 4 peut être mise à la terre, ou même aucune d'elles. L'essentiel est que l'écran conducteur disposé autour d'une électrode soit au même potentiel que l'autre électrode.

Le fonctionnement de cette installation sera décrite ci-dessous par son utilisation pour la mise en oeuvre du procédé selon l'invention. L'obtention d'un dépôt de silicium amorphe hydrogéné, sous forme d'un film sur un substrat, comprend généralement au moins les trois étapes suivantes :

- (A) préparation du substrat (nettoyage)
- (B) conditionnement du système (réacteur et substrat)
- (C) dépôt du film.

Le substrat peut être en verre, en métal, en matière synthétique ou autre. Les exemples cités ci-dessous se réfèrent à des substrats en verre de marque Dow Corning N° 7059 ou en verre revêtu d'un film métallique. Ces substrats ont une épaisseur de 0,8 mm. Dans l'étape A, le substrat est découpé aux dimensions appropriés (110 x 55 mm dans le cas présent), il est lavé dans plusieurs bains d'eau et d'alcool, puis il est monté sur un support interchangeable 25 pour être fixé à la première électrode 3.

Dans l'étape B, on fait le vide dans l'enceinte 2 du réacteur au moyen de la pompe 14 et ensuite des pompes 11 et 13 jusqu'à l'obtention d'une pression de $1\text{-}5 \times 10^{-4}$ Pa ($1\text{-}5 \times 10^{-6}$ mbar), puis on ferme la vanne 12 et l'on effectue un conditionnement à plasma d'hydrogène de la manière suivante. On chauffe l'enceinte au moyen des corps de chauffe 22 et 23 pendant environ une heure, de manière à obtenir une température superficielle d'environ 80°C qui peut être maintenue ensuite durant tout le processus de dépôt. En même temps, on chauffe l'électrode 3 et le support de substrat 25 à une température comprise entre 230 et 350° C. On introduit alors dans l'enceinte un débit d'hydrogène de l'ordre de 20 à 100 sccm ($cm^3$ NTP, par minute), que l'on fait circuler au moyen de la pompe primaire 14 dont la vitesse est réglée de façon à maintenir dans l'enceinte une pression comprise entre 10 et 50 Pa (0,1 et 0,5 mbar). Afin d'assurer un bon nettoyage du substrat et de l'enceinte, on produit un plasma par enclenchement du générateur à haute fréquence 5 pendant une durée de 10 à 60 minutes. Les conditions de pression, de puissance, etc sont choisies de manière que le plasma soit présent dans toute l'enceinte, tout en étant évidemment particulièrement dense entre les deux électrodes. Après ce conditionnement, le débit de gaz est interrompu et l'enceinte est vidée au moyen des pompes 11 et 13 jusqu'à environ $10^{-4}$ Pa ($10^{-6}$ mbar). On ferme alors la vanne 12 et le système est prêt pour l'étape C de dépôt proprement dit.

Dans cette étape C, les moyens 10 d'alimentation en gaz sont branchés de manière à délivrer à l'intérieur de l'enceinte 2 un gaz pur ou un mélange de gaz contenant au moins un composé de silicium, par exemple un mélange de silane ($SiH_4$) et d'hydrogène ($H_2$). La vanne 15 est ouverte et la pompe primaire 14 est actionnée de manière à maintenir une pression absolue **p** déterminée dans l'enceinte. Dès que la pression est stabilisée, on enclenche le générateur 5 pour produire un plasma entre les deux électrodes, et plus précisément entre le substrat 7 et la seconde électrode 4. Il est important que le plasma soit plus ou moins confiné à la zone comprise entre les deux électrodes, grâce à un choix judicieux des paramètres tels que la pression **p**, la distance **d** et la densité de puissance électrique. Le rôle de la fréquence **f** sera discuté plus loin.

D'autre part, tous les paramètres intervenant dans cette étape doivent être choisis de manière que la qualité du film de silicium se déposant sur le substrat soit aussi bonne que possible. A ce titre, les expériences ayant servi de base à la présente invention ont montré que les valeurs avantageuses de ces paramètres sont les suivantes pour un film de silicium amorphe hydrogéné:

distance entre électrodes $\quad\quad$ $d = 10\text{-}30$ mm

température du substrat $\quad\quad$ $T = 230\text{-}350°C$

pression absolue $\quad\quad$ $p = \overbrace{(0,1\text{-}0,5 \text{ mbar})}^{10 - 50 \text{ Pa}}$

mélange $SiH_4$ dans $H_2$ $\quad\quad$ $10\text{-}100\% \ SiH_4$

débit de gaz rapporté à $V_r$ $\quad\quad$ $0,3\text{-}5,0$ sccm/l

densité de puissance électrique $\quad\quad$ $P/V_p = 0,02\text{-}0,2 \ W/cm^3$

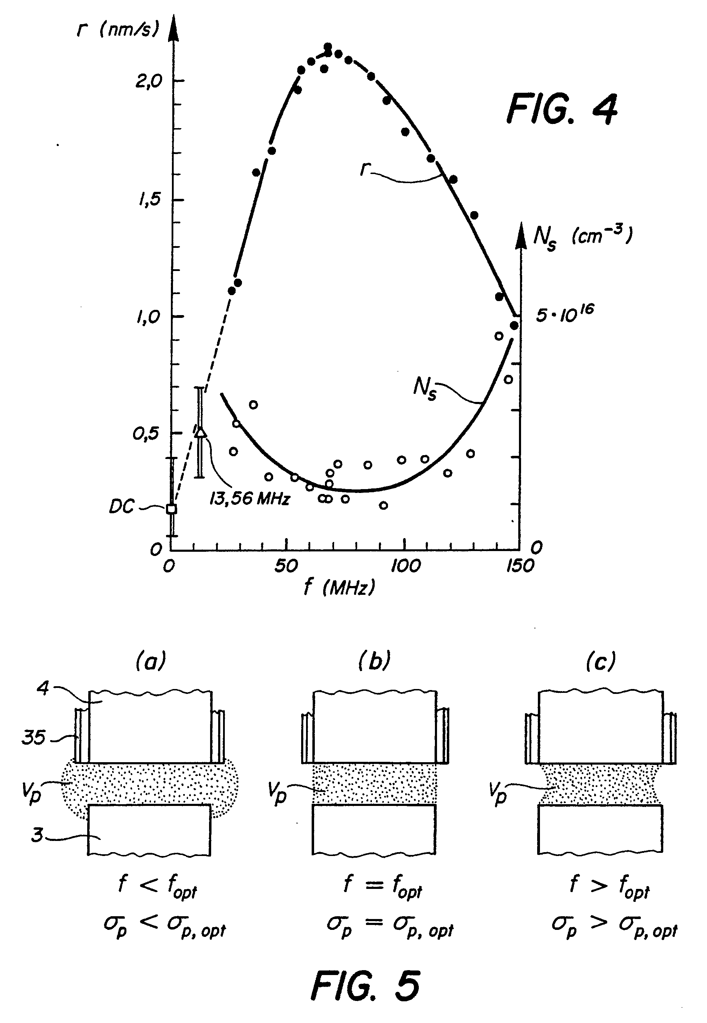

Un aspect essentiel de la présente invention est le fait que la fréquence **f** appliquée aux électrodes joue un rôle très important sur la vitesse de dépôt **r**, c'est-à-dire la vitesse à laquelle s'accroît l'épaisseur du film déposé. La fig. 3 montre qualitativement que, pour une distance **d** donnée, il existe dans la gamme des radiofréquences une fréquence optimale pour laquelle la vitesse de dépôt **r** est maximale. De plus, on observe que le taux de défauts $N_s$ du film (pour des durées égales de dépôt) est minimal justement pour cette fréquence optimale. Pour des épaisseurs égales, la courbe $N_s$ est plus aplatie. D'autre part on observe que, lorsque la distance **d** augmente, la fréquence optimale $f_{opt}$ correspondante augmente aussi, de sorte qu'on peut écrire :

$$\frac{f_{opt}}{d} \simeq 45 \ MHz/cm$$

au moins dans la gamme allant jusqu'à **f** = 200 MHz. On remarque également que, lorsque la valeur de **d** augmente, la valeur maximale de la vitesse de dépôt diminue et le taux minimal de défauts augmente, c'est-à-dire que les meilleurs résultats sont obtenus avec de faibles distances **d** si la fréquence **f** est optimale. Toutefois, il est bien connu que la valeur de **d** est limitée vers le bas par d'autres phénomènes. En pratique, une valeur **d** = 10 mm peut être considérée actuellement comme un minimum.

La fig. 4 montre plus en détail la répartition des valeurs expérimentales de la vitesse de dépôt **r** et du taux de défauts $N_s$ obtenues dans la gamme des fréquences **f** = 27,1-150 MHz avec les paramètres suivants :

| distance entre électrodes | d = 15 mm |
|---|---|

| température du substrat | T = 280°C _28 Pa_ |
|---|---|
| pression absolue | p = (0,28 mbar) |
| gaz | 100% $SiH_4$ |
| débit de gaz/$V_r$ | 1,3 sccm/l |
| densité de puissance | $P/V_p$ = 0,1 W/cm³ |
| durée de dépôt | environ 20 min. |

Les deux courbes **r** et $N_s$ sont des courbes corrélées. A titre de comparaison, on a également représenté sur cette figure des valeurs typiques des vitesses de dépôt obtenues avec des plasmas produits par tension continue (DC) et pour une fréquence de 13,56 MHz, ainsi que la dispersion des valeurs correspondantes fournies par la littérature. Dans le cas présent, on obtient des valeurs de **r** qui sont bien supérieures, déjà à la fréquence industrielle de 27,1 MHz et au moins jusqu'à 150 MHz. En dessous de 25 MHz, le taux, **r** chute rapidement. On remarque que, dans les conditions susmentionnées, la fréquence optimale est voisine de 70 MHz et permet d'obtenir des vitesses de dépôt **r** supérieures a 2,0 nm/s. En même temps, les valeurs de $N_s$ déterminées par la méthode PDS se trouvent dans la gamme de 1-2 x $10^{16}/cm^3$ pour une épaisseur d'environ 2 um, et inférieures à 2-3 x $10^{15}/cm^3$ pour une épaisseur d'environ 20 um. Il faut rappeler que la qualité d'un film de silicium, déterminée d'après cette méthode, est considérée comme bonne si la valeur de $N_s$ est inférieure à 5 x $10^{16}/cm^3$ pour des épaisseurs d'environ 1 $\mu$m.

Des résultats analogues peuvent être obtenus en appliquant le procédé susmentionné pour déposer sur le substrat un film semi-conducteur comprenant un alliage de silicium amorphe avec des éléments tels que l'azote, le phosphore, le bore etc. En particulier, le demandeur a obtenu expérimentalement, pour le dépôt d'un alliage Si-N en utilisant la même gamme de fréquences, des résultats qualitativement analogues à ceux de la fig. 4 à partir d'un mélange de gaz silane avec l'ammoniac et/ou l'azote. Les valeurs des paramètres indiqués ci-dessous ont permis d'obtenir des films de Si-N amorphe de bonne qualité :

| distance entre électrodes | d = 10-30 mm |
|---|---|
| température du substrat | T = 200-400°C |

| | _10-100 Pa_ |
|---|---|
| pression absolue | p = (0,1-1,0 mbar) |
| débit de silane/$V_r$ | 0,05-2,0 sccm/l |
| taux de mélange $SiH_4/NH_3$ | 0,03-0,3 |
| densité de puissance électrique | $P/V_p$ = 0,05-0,5 W/cm³ |

En particulier, des films de Si-N ayant une grande transparence optique et des champs de rupture diélectrique aussi hauts que 5-10 MV/cm ont pu être déposés à une vitesse de 0,5-1,0 nm/sec en utilisant les paramètres suivants :

distance entre électrodes $\quad$ **d** = 15 mm

température du substrat $\quad$ **T** = 300°C

pression absolue $\quad$ **p** = $\sqrt{}$(0,5 mbar) ~ 50 Pa

débit de silane/V$_r$ $\quad$ 0,4 sccm/l

taux de mélange SiH$_4$/NH$_3$ $\quad$ 0,1

densité de puissance électrique $\quad$ **P/V$_p$** = 0,1 W/cm³

L'existence d'une fréquence optimale peut être expliquée en ce qu'elle correspond à une valeur optimale de la conductivité $\sigma_p$ du plasma, pour un ensemble donné de paramètres. Ce phénomène est illustré par la fig. 5 pour différentes fréquences **f** (tous les autres paramètres étant maintenus constants, en particulier la puissance électrique appliquée). Sur cette figure, on a représenté en pointillé la zone où le plasma est lumineux (Volume **V$_p$**). Sur les schémas respectifs (a), (b) et (c), la fréquence **f** et la conductivité $\sigma_p$ sont respectivement inférieures, égales et supérieures aux valeurs optimales $f_{opt}$ et $\sigma_{p,opt}$. Ainsi, en choisissant la fréquence adéquate, on peut se placer dans le cas (b) et obtenir alors un effet d'autoconfinement du plasma qui permet d'atteindre des performances particulièrement bonnes. Cette méthode peut aussi être mise à profit pour éviter l'utilisation d'un grillage autour de la zone du plasma.

Bien entendu, la fréquence optimale dépend non seulement des paramètres mentionnés plus haut, mais aussi de la composition du gaz ou mélange gazeux utilisé. A l'aide d'une observation visuelle du phénomène illustré par la fig. 5, on peut déterminer d'une manière approximative la fréquence optimale pour les conditions effectives régnant dans le réacteur à plasma. Par ailleurs, on peut également envisager de choisir délibérément une fréquence qui s'écarte de l'optimum de façon à régler la vitesse de dépôt à une valeur inférieure à l'optimum, par exemple pour la production d'une couche particulièrement mince pendant une durée donnée, imposée par des contraintes particulières de fabrication, ou pour adapter l'efficacité du dopage d'une couche à la valeur désirée. Il faut aussi noter qu'on peut utiliser des fréquences respectives différentes pour l'étape de conditionnement du système et l'étape de dépôt du film de silicium.

## Revendications

1. Procédé de dépôt d'un film semi-conducteur de silicium amorphe hydrogéné et/ou d'un alliage de silicium amorphe hydrogéné sur un substrat (7) dans une enceinte à plasma (2) contenant au moins une paire d'électrodes (3 et 4) couplée à un générateur électrique à haute fréquence (5), dans lequel on relie le substrat à une électrode, le substrat étant placé à une distance **d** de l'autre électrode, on introduit dans l'enceinte un gaz contenant au moins un composé de silicium, et l'on applique aux électrodes une puissance électrique de haute fréquence pour produire un plasma entre les électrodes, caractérisé en ce que la fréquence **f** est comprise entre 25 et 150 MHz, et en ce que le rapport **f/d** entre la fréquence et la distance est compris entre 30 et 100 MHz/cm.

2. Procédé selon la revendication 1, caractérisé en ce que la distance **d** est comprise entre 1 et 3 cm.

3. Procédé selon la revendication 1 ou 2, caractérisé en ce que le rapport **f/d** est compris entre 30 et 80 MHz/cm.

4. Procédé selon la revendication 3, caractérisé en ce que la fréquence **f** est comprise entre 30 et 100 MHz et la distance **d** est comprise entre 1 et 2,5 cm.

5. Procédé selon la revendication 1, caractérisé en ce que le rapport entre la puissance électrique **P** dissipée dans le plasma et mesurée aux bornes des deux électrodes et le volume **V$_p$** du plasma se trouvant entre les deux électrodes est compris entre 0,02 et 0,2 W/cm³.

6. Procédé selon la revendication 1, caractérisé en ce que l'on maintient dans l'enceinte, pendant le dépôt, une pression comprise entre 10 et 50 Pa (0,1 et 0,5 mbar).

7. Procédé selon la revendication 1, caractérisé en ce que l'on maintient le substrat, pendant le dépôt, à une température comprise entre 230 et 350° C.

**8.** Procédé selon la revendication 1, caractérisé en ce que le gaz introduit dans l'enceinte comprend une ou plusieurs des substances suivantes : silane, disilane et/ou des silanes d'ordre supérieur, tétrafluorure de silicium, hydrogène.

**9.** Procédé selon la revendication 8, caractérisé en ce que ledit gaz comprend une ou plusieurs des substances suivantes : germane, tétrafluorure de germanium, méthane, tétrafluorure de carbone, azote, ammoniac, phosphine, diborane.

**10.** Procédé selon la revendication 8, caractérisé en ce que le gaz de silane est introduit dans l'enceinte à un débit compris entre 0,3 et 2,0 sccm ($cm^3$ NTP/min) par litre de volume intérieur utile ($V_r$) de l'enceinte, et de préférence approximativement 1,2 sccm/l.

**11.** Procédé selon la revendication 8, pour le dépôt d'un film d'alliage silicium-azote, caractérisé en ce que le gaz introduit dans l'enceinte comprend un mélange de silane et d'ammoniac dans un volumique compris entre 0,03 et 0,3 et en ce que la distance **d** entre les électrodes est comprise entre 1 et 3 cm.

**12.** Installation pour la mise en oeuvre du procédé selon la revendication 1, comportant un générateur de radiofréquences (5), un réacteur à plasma (1) pourvu d'une enceinte (2) renfermant deux électrodes (3 et 4) couplées au générateur par l'intermédiaire d'un réseau d'adaptation (6), des moyens (10) pour introduire des gaz dans l'enceinte et des moyens (11 à 15) pour extraire les gaz de l'enceinte, l'une des deux électrodes étant pourvue d'un support pour le substrat (7), et l'autre électrode étant disposée à une distance **d** en face du substrat, caractérisée en ce que la fréquence **f** délivrable par le générateur est comprise entre 25 et 150 MHz, et en ce que le rapport **f/d** est compris entre 30 et 100 MHz/cm.

**13.** Installation selon la revendication 12, caractérisée en ce que l'une (4) des électrodes est entourée latéralement par un écran conducteur (35) espacé de l'électrode, cet écran étant au même potentiel que l'autre électrode (3), et en ce que l'écran (35) est séparé de l'électrode qu'il entoure par une gaine (36) en matière diélectrique, de préférence en matière céramique.

## Claims

**1.** Process for depositing a semiconductor film of amorphous hydrogenated silicon and/or of an alloy of amorphous hydrogenated silicon on a substrate (7) in a plasma chamber (2) containing at least one pair of electrodes (3 and 4) connected to a high-frequency electric generator (5), wherein the substrate is connected to one electrode, the substrate being placed at a distance **d** from the other electrode, a gas containing at least one silicon compound is introduced into the chamber, and high-frequency electrical power is applied to the electrodes to produce a plasma between the electrodes, characterized in that the frequency **f** is included between 25 and 150 MHz, and in that the ratio **f/d** between the frequency and said distance is included between 30 and 100 MHz/cm.

**2.** Process according to claim 1, characterized in that the distance **d** is included between 1 and 3 cm.

**3.** Process according to claim 1 or 2, characterized in that the ratio **f/d** is included between 30 and 80 MHz/cm.

**4.** Process according to claim 3, characterized in that the frequency **f** is included between 30 and 100 MHz and the distance **d** is included between 1 and 2.5 cm.

**5.** Process according to claim 1, characterized in that the ratio between the electrical power P dissipated in the plasma and measured at the terminals of the two electrodes and the volume $V_p$ of the plasma present between the two electrodes is included between 0.02 and 0.2 $W/cm^3$.

**6.** Process according to claim 1, characterized in that a pressure included between 10 and 50 Pa (0.1 and 0.5 mbar) is maintained in the chamber during the deposition.

**7.** Process according to claim 1, characterized in that the substrate is maintained, during the deposition, at a temperature included between 230 and 350° C.

8. Process according to claim 1, characterized in that said gas introduced into the chamber comprises one or several of the following substances: silane, disilane and/or silanes of higher order, silicon tetrafluoride, hydrogen.

9. Process according to claim 8, characterized in that said gas comprises one or several of the following substances: germane, germanium tetrafluoride, methane, carbon tetrafluoride, nitrogen, ammonia, phosphine, boroethane.

10. Process according to claim 8, characterized in that silane gas is introduced into the chamber at a flow rate included between 0.3 and 2.0 sccm (cm$^3$ NTP/min) per litre of useful internal volume ($V_r$) of the chamber, and preferably approximately 1.2 sccm/l.

11. Process according to claim 8, for the deposition of a film of silicon-nitrogen alloy, characterized in that the gas introduced into the chamber comprises a mixture of silane and ammonia in a voluminal ratio included between 0.03 and 0.3 and in that the distance **d** between the electrodes is included between 1 and 3 cm.

12. Installation for implementing the process according to claim 1, comprising a radiofrequency generator (5), a plasma reactor (1) provided with a chamber (2) containing two electrodes (3 and 4) connected to the generator via a matching grid (6), means (10) for introducing gases into the chamber and means (11 to 15) for extracting the gases from the chamber, one of the two electrodes being provided with a support for the substrate (7), and the other electrode being disposed at a distance **d** opposite the substrate, characterized in that the frequency **f** which may be delivered by the generator is included between 25 and 150 MHz, and in that the ratio **f/d** is included between 30 and 100 MHz/cm.

13. Installation according to claim 12, characterized in that one (4) of the electrodes is laterally surrounded by a conductive screen (35) spaced from the electrode, this screen being at the same potential as the other electrode (3), and in that the screen (35) is separated from the electrode it surrounds by a sheath (36) of dielectric material, preferably of ceramic material.

**Patentansprüche**

1. Verfahren zum Auftragen eines Halbleiterfilms aus amorphem, hydriertem Silizium und/oder aus einer Legierung von amorphem, hydriertem Silizium auf ein Substrat (7) in einem Plasmaraum (2), der mindestens ein Paar von Elektroden (3 und 4) enthält, das mit einem elektrischen Hochfrequenzgenerator (5) gekoppelt ist, bei dem das Substrat in einer Elektrode verbunden wird, wobei das Substrat bei einer Entfernung (d) von der anderen Elektrode angeordnet wird, ein Gas in den Plasmaraum eingeführt wird, das mindestens eine Siliziumverbindung enthält, und eine elektrische Hochfrequenzenergie an den Elektroden angelegt wird, um zwischen den Elektroden ein Plasma zu bilden,
   **dadurch gekennzeichnet, daß**
   die Frequenz (f) zwischen 25 und 150 MHz liegt und daß das Verhältnis f/d zwischen der Frequenz und der Entfernung (d) zwischen 30 und 100 MHz/cm liegt.

2. Verfahren gemäß Anspruch 1,
   **dadurch gekennzeichnet, daß**
   die Entfernung (d) zwischen 1 und 3 cm liegt.

3. Verfahren gemäß Anspruch 1 oder 2,
   **dadurch gekennzeichnet, daß**
   das Verhältnis (f/d) zwischen 30 und 80 MHz/cm liegt.

4. Verfahren gemäß Anspruch 3,
   **dadurch gekennzeichnet, daß**
   die Frequenz (f) zwischen 30 und 100 MHz liegt und die Entfernung (d) zwischen 1 und 2,5 cm liegt.

5. Verfahren gemäß Anspruch 1,
   **dadurch gekennzeichnet, daß**
   das Verhältnis zwischen der elektrischen Energie (P), die in das Plasma abgestrahlt wird und an den Klemmen der beiden Elektroden gemessen wird, und dem Plasmavolumen VP, das zwischen den beiden Elektroden vorhanden ist, zwischen 0,02 und 0,2 $W/cm^3$ liegt.

6. Verfahren gemäß Anspruch 1,
**dadurch gekennzeichnet,** daß
während des Auftragvorgangs ein Druck zwischen 10 und 50 Pa (0,1 und 0,5 mbar) in dem Plasmaraum aufrechterhalten bleibt.

7. Verfahren gemäß Anspruch 1,
**dadurch gekennzeichnet,** daß
während des Auftragvorgangs das Substrat bei einer Temperatur zwischen 230 und 350°C gehalten bleibt.

8. Verfahren gemäß Anspruch 1,
**dadurch gekennzeichnet,** daß
das Gas, das in den Plasmaraum eingeführt wird, einen oder mehrere der folgenden Stoffe Silane, Disilane und/oder Silane höherer Ordnung, Siliziumtetrafluorid, Wasserstoff enthält.

9. Verfahren gemäß Anspruch 8,
**dadurch gekennzeichnet,** daß
das besagte Gas einen oder mehrere der folgenden Stoffe: Germanium, Germaniumtetrafluorid, Methan, Kohlenstofftetrafluorid, Stickstoff, Ammoniak, Phosphine, Diborane, enthält.

10. Verfahren gemäß Anspruch 8,
**dadurch gekennzeichnet,** daß
das Silangas in den Plasmaraum mit einer Durchsatzmenge zwischen 0,3 und 2,0 sccm ($cm^3$ NTP/min) je Liter vom inneren Nutzinhalt (Vr) des Plasmaraums und vorzugsweise annähernd von 1,2 sccm/Liter eingeführt wird.

11. Verfahren gemäß Anspruch 8,
für das Auftragen eines Films aus einer Silizium-Stickstofflegierung,
**dadurch gekennzeichnet,** daß
das Gas, das in den Plasmaraum eingeführt wird, aus einem Gemisch von Silane und Ammoniak in einem Volumenverhältnis zwischen 0,03 und 0,3 besteht und daß die Entfernung (d) zwischen den Elektroden zwischen 1 und 3 cm liegt.

12. Vorrichtung für das Anwenden des Verfahrens gemäß Anspruch 1, bestehend aus einem Hochfrequenzgenerator (5), einem Plasmareaktor (1) mit einem Raum (2), der zwei Elektroden (3 und 4) enthält, die über ein Adaptionsnetz (6) mit dem Generator (5) gekoppelt sind, aus Einrichtungen (10) für das Einführen des Gases in den Plasmaraum (2) und Einrichtungen (11 bis 15) für das Entziehen der Gase aus dem Plasmaraum (2), wobei eine der beiden Elektroden mit einer Auflage für das Substrat (7) versehen ist und die andere Elektrode in einer Entfernung (d) gegenüber dem Substrat angeordnet ist,
**dadurch gekennzeichnet,** daß
die Frequenz (f), die von dem Generator (5) abgegeben wird, zwischen 25 und 150 MHz liegt und daß das Verhältnis (f/d) zwischen 30 und 100 MHz/cm liegt.

13. Vorrichtung gemäß Anspruch 12,
**dadurch gekennzeichnet,** daß
eine (4) der Elektroden seitlich von einem leitenden Schirm (35) umgeben ist, der von der Elektrode absteht, wobei dieser Schirm das gleiche Potential wie die andere Elektrode (3) aufweist, und daß der Schirm (35) von der Elektrode (4), die er umgibt, durch eine Hülle (36) aus dielektrischem Stoff, vorzugsweise aus Keramik-Werkstoff, abgetrennt ist.

FIG. 1

$d_1 < d_2 < d_3$

$d_1 < d_2 < d_3$

FIG. 3

# FIG. 2

*FIG. 4*

*FIG. 5*